# EUROPÄISCHE PATENTSCHRIFT

(11) **EP 2 824 076 B1**
(45) Veröffentlichungstag und Bekanntmachung des Hinweises auf die Patenterteilung: **16.11.2016**
(21) Anmeldenummer: 14175815.1
(22) Anmeldetag: 04.07.2014
(51) Int. Cl.: C01G 51/00, H01L 35/08, H01L 35/34

(54) **Herstellung von Skutterudit**
Production of skutterudite
Fabrication de smaltine

(30) Priorität: 08.07.2013 DE 102013213334
(43) Veröffentlichungstag der Anmeldung: 14.01.2015
(73) Patentinhaber: Deutsches Zentrum für Luft- und Raumfahrt e.V., 51147 Köln (DE)
(72) Erfinder: Sesselmann, Andreas, 50668 Köln (DE); Stiewe, Christian, 51143 Köln (DE); Johansen, Kai, 4620 Kristiansand (NO)
(74) Vertreter: dompatent von Kreisler Selting Werner - Partnerschaft von Patent- und Rechtsanwälten mbB

(56) Entgegenhaltungen:
- EP-A1- 1 083 610
- US-A1- 2006 053 969
- PEI Y ET AL: "Synthesis and thermoelectric properties of KyCo4Sb12", APPLIED PHYSICS LETTERS, AMERICAN INSTITUTE OF PHYSICS, US, Bd. 89, Nr. 22, 28. November 2006 (2006-11-28), Seiten 221107-221107, XP012087250, ISSN: 0003-6951, DOI: 10.1063/1.2397538
- LI HAN ET AL: "High performance InxCeyCo4Sb12 thermoelectric materials with in situ forming nanostructured InSb phase", APPLIED PHYSICS LETTERS, AMERICAN INSTITUTE OF PHYSICS, US, Bd. 94, Nr. 10, 13. März 2009 (2009-03-13) , Seiten 102114-102114, XP012118316, ISSN: 0003-6951, DOI: 10.1063/1.3099804
- LI D ET AL: "Synthesis and high temperature thermoelectric properties of calcium and cerium double-filled skutterudites Ca0.1CexCo4Sb12; Synthesis and high temperature thermoelectric properties of double-filled skutterudites Ca0.1CexCo4Sb12", JOURNAL OF PHYSICS D: APPLIED PHYSICS, INSTITUTE OF PHYSICS PUBLISHING LTD, GB, Bd. 42, Nr. 10, 21. Mai 2009 (2009-05-21), Seite 105408, XP020148971, ISSN: 0022-3727, DOI: 10.1088/0022-3727/42/10/105408
- TANG XINFENG ET AL: "Synthesis and thermoelectric properties of double-atom-filled skutterudite compounds CamCenFexCo4-xSb12", JOURNAL OF APPLIED PHYSICS, AMERICAN INSTITUTE OF PHYSICS, US, Bd. 100, Nr. 12, 19. Dezember 2006 (2006-12-19), Seiten 123702-123702, XP012089301, ISSN: 0021-8979, DOI: 10.1063/1.2375017

## Beschreibung

Gegenstand der Erfindung ist die effektive und robuste Herstellung des thermoelektrischen Materials Skutterudit mit einer definierten Materialstöchiometrie.

Zur Herstellung der Vorprodukte dieser Materialkomposition kann hierbei auf Reinstelemente verzichtet werden. Unterstützt wird dies durch ein integriertes Reinigungsverfahren während des Gasverdüsungsprozesses. Die Verfahrenskette ist für die Skutteruditkomposition RᵢS_{y}A₄B_{12-y} optimiert, dabei ist mindestens ein Rᵢ Element aus der Gruppe der Seltenen Erden (beispielsweise Ce) und/oder der Gruppe 1 und 2 (beispielsweise Ba) und S_{y} aus der Gruppe 13 und/oder 14 (wie beispielsweise In, Ga, Sn).

Thermoelektrische Materialien, wie die Materialklasse der mehrfach gefüllten Skutterudite, werden im Stand der Technik in einem aufwands- und zeitintensiven Prozess hergestellt. Mehrfach gefüllte Skutterudite habe die chemische Formel RᵢS_{y}A₄B_{12-y}. Rᵢbezeichnet dabei mehrere Elemente (i=1,2,3,...) aus der Gruppe der (Erd-)-Alkalielemente, der Gruppe der Seltenen Erden (beispielsweise Ce, La) und S_{y} aus der Gruppe 13 und 14 (wie beispielsweise In, Ga, Sn)-141369ep HPJ/EBO/ko 04.07.2014

Gruppe. A bezeichnet ein chemisches Element aus der Gruppe der Übergangsmetallen (beispielsweise Co) und B bezeichnet ein chemisches Element aus der Gruppe 15 (beispielsweise Sb). A kann durch T Elemente der Gruppe 8 und 10 (beispielsweise Co durch Fe) stöchiometrisch ersetzt werden (A₄₋ᵤTᵤ)Gruppe. Somit lautet die erweiterte chemische Formel für einen mehrfach gefüllten Skutterudit RᵢS_{y}A₄₋ᵤTᵤB_{12-y}. Thermoelektrisch effektive Skutteruditmaterialien bestehen meistens aus den Basiskompositionen CoSb₃ bzw. FeSb₃ und haben Elektronen beziehungsweise Löcher als Majoritätsladungsträger. Neue Erkenntnisse bezogen auf die Verwendung von Elementen aus der Gruppe 13 und 14 haben ergeben, dass diese Elemente (wie beispielsweise In, Ga und Sn) zwei verschiedene Gitterplätze im Skutterudit besetzen können. Hierbei besetzen die Elemente aus der Gruppe 13 und 14 den Gitterplatz Rᵢ und den Gitterplatz B im Skutterudit RᵢS_{y}A₄₋ᵤTᵤB_{12-y}. Somit muss die Stöchiometrie des Elements B bei Verwendung der Elemente aus Gruppe 13 und 14 angepasst werden.

Die typischen Auswirkungen verschiedener Rᵢ Atome auf das Basismaterial A₄B₁₂ bzw. AB₃ (ungefüllter Skutterudit) sind eine Erhöhung der elektrischen Leitfähigkeit σ, die Erniedrigung der Gitterwärmeleitfähigkeit κ und die moderate Erniedrigung des absoluten Seebeckkoeffizienten |S|. Alle drei Parameter sind maßgebend für die thermoelektrische Effizienz des Materials und kann mathematisch im thermoelektrischen Gütefaktor zusammengefasst werden: Z= σS²/κ.

Die Herstellung eines Skutterudits benötigt zumeist die Verwendung von Reinstmaterialien, die unter anderem eine hohe Affinität zur Oxidation aufweisen (beispielsweise Ce in CaO₂). Die (teilweise) Oxidation der Edukte hat zur Folge, dass die Materialkomposition nicht eingehalten werden bzw. gar nicht erst entstehen kann. Dies wiederum beeinträchtigt die Effektivität eines thermoelektrischen Materials nachhaltig. Oxidverbindungen der Edukte können zudem giftig sein (beispielsweise BaₓO_{y}) und weiterhin reagieren die Ausgangselemente teilweise mit einer starken exothermen Reaktion (beispielsweise Ce und Sb). Für die technische Handhabbarkeit stellen diese Punkte ein großes Hindernis dar.

Verschiedene Herstellungsvarianten für das Skutteruditmaterial sind in der Literatur angegeben (siehe Tabelle 1)

| Literaturnr. | Komposition | Jahr | Stöchiometrie | Prekusor | Tiegelmaterial | Schmelzvorgang | | Wärmebehandlung | | Methode | Kompaktierungsvorgang | |
|---|---|---|---|---|---|---|---|---|---|---|---|---|
| | | | | | | **Zeit in h** | **T. in °C** | **Zeit in h** | **T. in °C** | | **Zeit in min.** | **T in °C** |
| 1 | K_{y}Co₄Sb₁₂ | 2006 | stöchiometrisch | | Graphit | | 1077 | 172 | 677 | SPS | 10 | 527 |
| 2 | Ba_{y}Co₄Sb₁₂ | 2001 | | Sb₃Ba | - | 24 | 1050 | 72 | 700 | SPS | 15 | 600 |
| 3 | Yb_{0.3}Co₄Sb_{12+y} | 2008 | Sb (bis +0.05%) | | SiO2 | 20 | 1100 | 0 | Melt spinning | SPS | 5 | 550 |
| 4 | In_{X}Ce_{y}Co₄Sb₁₂ | 2009 | stöchiometrisch | | SiO2 | 30 | 1100 | 168 | 680 | SPS | 5 | 630 |
| 5 | Ca_{0.1}CeₓCo₄Sb₁₂ | 2009 | Sb (+0.25%) | | SiO2 | 48 | 1000 | 168 | 620 | HUP | 120 | 500 |
| 6 | In_{y}Yb_{0.2}Co₄Sb₁₂ | 2009 | stöchiometrisch | | SiO2 | 24 | 1050 | 72 | 650 | SPS | 20 | 600 |
| 7 | Ca_{X}Co₄Sb₁₂ | 2004 | | | He/H2 | 84 | 750 | 84 | 620 | HUP | 120 | 700 |
| 8 | TiₓCo_{4-y}Fe_{y}Sb₁₂ | 2000 | stöchiometrisch | | SiO2 | 30 | 1050 | 48 | 500 | HUP | 40 | 500 |
| 9 | CaₘCeₙFeₓCo₄₋ₓ Sb₁₂ | 2006 | stöchiometrisch | | SiO2 | 30 | 1100 | 168 | 680 | SPS | 7 | 630 |
| 10 | MmFe₄Sb₁₂ | 2009 | Sb (+1%) | FeSb₂ + Sb | SiO2 | | 950 | 72 | 600 | HUP | | 400 |
| 11 | BaₓIn_{y}Co₄Sb_{12-z} | 2007 | | | Graphit | 24 | 1100 | 120 | 660 | SPS | 7 | 630 |
| 12 | InₓCo₄Sb₁₂ | 2011 | stöchiometrisch | CeCo | Quarzglas | 1 | 1150 | 168 | 700 | DSP | 30 | 630 |

[1] Pei, et al., Synthesis and thermoelectric properties of KyCo4Sb12, Applied Physics Letters, AIP, 2006, 89, 221107
[2] Chen, et al., Anomalous barium filling fraction and n-type thermoelectric performance of BayCo4Sb12, Journal of Applied Physics, AIP, 2001, 90, 1864-1868
[3] Li, et al., Rapid preparation method of bulk nanostructured Yb0.3Co4Sb12+y compounds and their improved thermoelectric performance, Applied Physics Letters, AIP, 2008, 93, 252109
[4] Li, et al., High performance InxCeyCo4Sb12 thermoelectric materials with in situ forming nanostructured InSb phase, Applied Physics Letters, AIP, 2009, 94, 102114
[5] Li, et al., Synthesis and high temperature thermoelectric properties of calcium and cerium double-filled skutterudites Ca0.1CexCο4Sb12, Journal of Physics D: Applied Physics, 2009, 42, 105408
[6] Peng, et al., Synthesis and Thermoelectric Properties of the Double-Filled skutterudite Yb0.2InyCO4Sb12, Journal of Electronic Materials, 2009, 38, 981-984
[7] Puyet, et al., Synthesis and crystal structure of CaxCo4Sb12 skutterudites, Journal of Solid State Chemistry, 2004, 177, 2138 - 2143
[8] Sales, et al., Thermoelectric properties of thallium-filled skutterudites, Phys. Rev. B, American Physical Society, 2000, 61, 2475-2481
[9] Tang, et al., Synthesis and thermoelectric properties of doubleatom-filled skutterudite compounds CamCenFexCo4-xSb12, Journal of Applied Physics, AIP, 2006, 100, 123702
[10] MmFe4Sb12- and CoSb3-based nano-skutterudites prepared by ball milling: Kinetics of formation and transport properties, Journal of Alloys and Compounds, 2009, 481, 106 - 115
[11] Synthesis and high temperature transport properties of barium and indium double-filled skutterudites BaxInyCo4Sb12-z Journal of Applied Physics, AIP, 2007, 102, 113708
[12] Sesselmann, A., Investigation on the Thermoelectric and Structural Properties of Cobalt-Antimony based Skutterudites and Modifications with Indium and Rare-Earth Elements, PhD thesis, University of Augsburg, 2012

EP1083610 offenbart die Herstellung von thermoelektrischen Materialien am Beispiel von siliziumbasierten Zusammensetzungen. Hierzu werden Ausgangsmaterialien in elementarer Form in einer Argonatmosphäre im Lichtbogen geschmolzen, und die Schmelze einem Gasverdüsungsschritt und anschliessender Abkühlung unterworfen. Das erhaltene pulverförmige Produkt durchläuft abschliessend einen Presssinterschritt bei erhöhter Temperatur. US2006/0053969 offenbart thermoelektrische Materialien, darunter solche mit Skutterudit-Struktur CoSb3, und ihre Herstellung dadurch, dass Metallpulver verschmolzen werden, die Schmelze einem Gasverdüsungschritt und Abkühlung unterzogen wird, und das erhaltene Pulver kompaktiert wird unter hohem Druck und erhöhter Temperatur.

Das erfindungsgemäße Herstellungsverfahren umfasst die Herstellung der Vorprodukte, die Verarbeitung der Legierung und anderer Edukte in einem Gasverdüsungsprozess und das Kompaktieren des Pulvermaterials mittels einer stromgeführten Sinterpresse. Hierbei kann die stromgeführte Sinteranlage die übliche Wärmebehandlung des Skutterudits ersetzen.

Eine erste Ausführungsform der vorliegenden Erfindung betrifft ein Verfahren zur Herstellung von Skutterudit der chemischen Formel

RᵢS_{y}A₄B_{12-y},

wobei
Rᵢ für ein oder mehrere Elemente (i=1,2,3,...) aus der Gruppe der (Erd-)Alkalielemente, der Gruppe der Seltenen Erden (beispielsweise Ce, La), steht,
S_{y} für Füllelemente der Gruppe 13 und 14, die teilweise den Gitterplatz des Atoms B besetzen (insbesondere Sn, In, Ga), steht,
A für wenigstens ein chemisches Element aus der Gruppe 15 (insbesondere Sb) steht, wobei A durch wenigstens ein Element der Gruppe 8 und 10 (insbesondere Co durch Ni) stöchiometrisch ersetzt werden kann, und
B für wenigstens ein chemisches Element aus der Gruppe der Übergangsmetalle steht (beispielsweise Co, Fe), wobei B durch wenigstens ein Element der Gruppe 14 und 16 ersetzt werden kann (beispielsweise Sb durch Sn) durch
   (a) Verschmelzen der elementaren Metalle und gegebenenfalls weiterer Edukte in einem Lichtbogen unter Inertgasatmosphäre, wobei man wenigstens eines der Ausgangsmaterialien in Form einer geschlossenen Folie einsetzt, in die wenigstens ein Ausgangsmaterial eingeschlossen ist,
   (b) anschließendes Überführen in eine Gasverdüsungsanlage,
   (c) anschließendes Abkühlen auf Raumtemperatur (20 bis 25 °C) und
   (d) anschließendes Kompaktieren des erhaltenen Pulvers unter Wärmezufuhr und Druck.

Vorprodukte können bei diesem erfindungsgemäßen Herstellungsverfahren wie folgt hergestellt werden.

Es wird eine Legierung aus den Elementen der Skutteruditkomposition hergestellt (beispielsweise mit Hilfe eines Lichtbogenofens, Elektronenstrahlverfahren). Weiterhin kapselt man Sauerstoff-sensitive Elemente mit Hilfe einer hochtemperaturbeständigen Folie ein. Die Folie besteht dabei aus einem Element, beziehungsweise Elementen der Skutteruditkomposition und wird durch eine mechanische Vorrichtung luftdicht verschlossen.

Dies hat den Vorteil, dass eine starke exotherme Reaktion bei dem Gebrauch von elementaren Edukten während des Gasverdüsungsprozesses verhindert wird. Einer Beschädigung der Gasverdüsungsanlage wird dadurch vorgebeugt. Weiterhin zeigen sich die Legierungen weniger Sauerstoff-sensitiv. Dies gilt vor allem für Verbindungen mit Seltene Erden Elementen.

Weiterhin hat es den Vorteil der einfachen Handhabung von Sauerstoffsensitiven Elementen. Des Weiteren kann bei eingekapselten Elementen eine überstöchiometrische Einwaage vorgebeugt werden. Die überstöchiometrische Einwaage ist dann notwendig, wenn die einzelnen Elemente stark unterschiedliche Schmelztemperaturen besitzen und sich somit hohe Partialdampfdrücke entwickeln können. Diese Elemente setzen sich an den Innenwänden des Ofens in der Gasverdüsungsanlage ab und es entsteht eine Endstöchiometrie des Materials, die verschieden von der Anfangsstöchiometrie ist. Dies gilt vor allem für Elemente wie Indium, die einen wesentlich niedrigeren Schmelzpunkt gegenüber Kobalt oder Antimon besitzt. Dadurch kann sich das eingekapselte Element nur in der Innenwand der Folie niederschlagen. Durch die hohe Schmelztemperatur der Folie wird ein Abdampfen des einzelnen Elements unterbunden. Beim Aufschmelzen der Folie geht das eingekapselte Material sofort eine chemische Reaktion mit der Umgebung ein. Die Stöchiometrie kann somit erhalten bleiben. Beide Varianten zur Herstellung der Vorprodukte werden unter inerter Atmosphäre durchgeführt.

Das Material kann in der Gasverdüsungsanlage anschließend aufgeschmolzen und als Schmelze homogenisiert werden. Die Schmelze wird innerhalb der Anlage durch eine kleine Öffnung geführt und durch einen Gasstrahl abrupt abgekühlt. Der Gasstrahl beinhaltet herkömmlicherweise ein inertes Gas. Für den zu beschreibenden Herstellungsprozess besteht das Gas für den Gasstrahl insbesondere aus einem inerten Anteil (beispielsweise Ar) und einem reaktiven Anteil (beispielsweise H₂). Der reaktive Anteil des Gasgemischs kann einen Volumenanteil des Gases von bis zu 5% aufweisen. Durch die besondere Eigenschaft des Gasstrahls und den direkten Kontakt mit der Schmelze können vorhandene Sauerstoff- und Kohlenstoffanteile in der Schmelze mit dem reaktiven Anteil des Gasstrahls eine chemische Reaktion eingehen und werden dabei aus dem Skutteruditmaterial gelöst.

Das aus dem Gasverdüsungsverfahren gewonnene Pulvermaterial hat die Ziel-Stöchiometrie des thermoelektrischen Materials, verfügt jedoch nicht über die gewünschte Kristallstruktur der Skutteruditphase. Das feinkörnige Pulver besitzt jedoch die Eigenschaft, dass nur kurze Diffusionswege der Atome notwendig sind, um eine Kristallumwandlung zu erreichen und ist demnach herkömmlichen Pulverherstellungsmethoden im Sinne der Homogenisierung und Handhabung überlegen. Weiterhin lassen sich verschiedene eingesetzte Elemente nicht in einem herkömmlichen Pulverherstellungsverfahren bearbeiten, da es beispielsweise nicht möglich ist, Indium bei beziehungsweise oberhalb der Raumtemperatur zu mahlen.

Anschließend wird eine stromgeführte Kompaktierung durchgeführt, die sich durch gleichzeitiges Erhitzen über die Joulsche Wärme und Kompaktieren auszeichnet. Durch die Druck- und Wärmebehandlung des Pulvers wird eine fast vollständige Kristallstrukturumwandlung in die Skutteruditphase erzielt. Der stromgeführte Kompaktierungsschritt kann eine Dauer von mehreren Minuten bis zu wenigen Stunden haben und unterscheidet sich somit maßgeblich von anderen herkömmlichen Wärmebehandlungsschritten für das Skutteruditmaterial, die typischerweise bei höheren Temperaturen und längerer Dauer durchgeführt werden (bis zu einer Woche).

Das hergestellte Skutteruditmaterial zeichnet sich durch eine hohe Phasenreinheit mit einem geringen Anteil an fein verteilten Verunreinigungen aus. Diese feine Verteilung der Verunreinigungen, die durch das Gasverdüsungsverfahren hervorgerufen worden ist, kann dazu beitragen die Wärmeleitfähigkeit des Gesamtmaterials zu erhöhen. Dies ist möglich durch eine erhöhte Dichte der Korngrenzen, die zum Wärmeübertrag bedeutend beitragen. Weiterhin ist durch die feine Verteilung eine Ostwald-Reifung der Verunreinigung, also ein Wachstum gleichartiger Phasen, durch die örtliche Trennung erschwert. Durch die Präsenz der Verunreinigung vor allem an Korngrenzen der Skutteruditphase können die Fremdphasen ebenso eine Erhöhung der Materialhärte hervorrufen. Dies ist für technische Anwendung des thermoelektrischen Materials von großer Bedeutung.

Thermoelektrische Materialien können unter Ausnutzung des Seebeck-Effekts, aus einem Temperaturunterschied eine messbare Spannung erzeugen. Dieser Effekt kann in einem thermoelektrischen Thermogenerator dazu genutzt werden, um Wärmeenergie in elektrische Energie umzuwandeln.

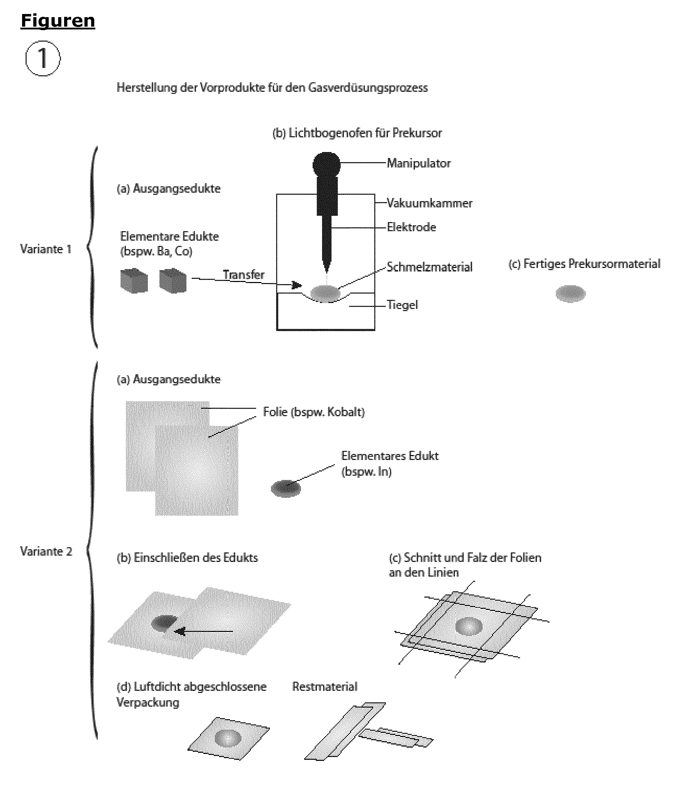

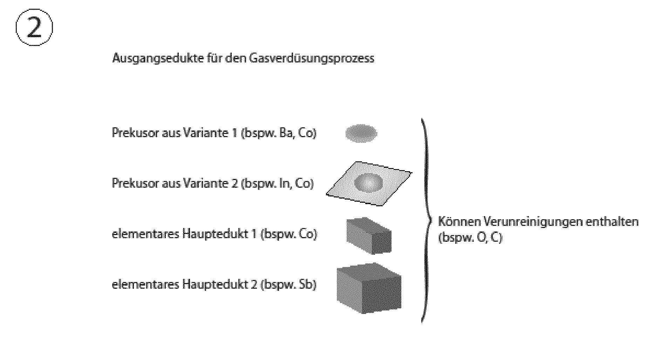

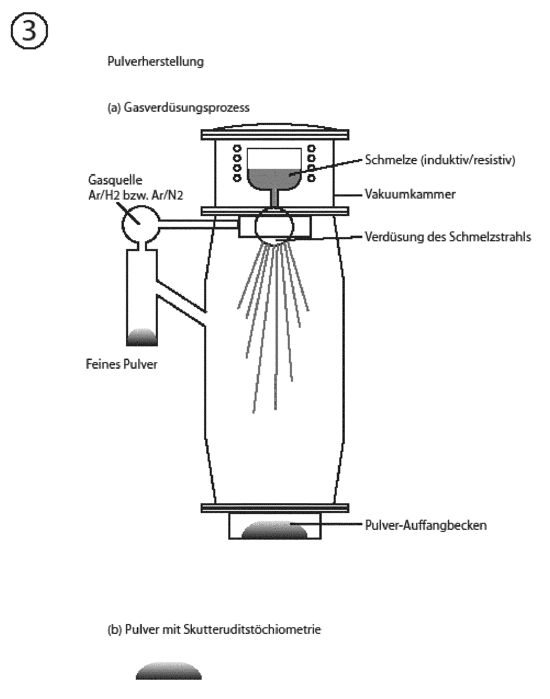

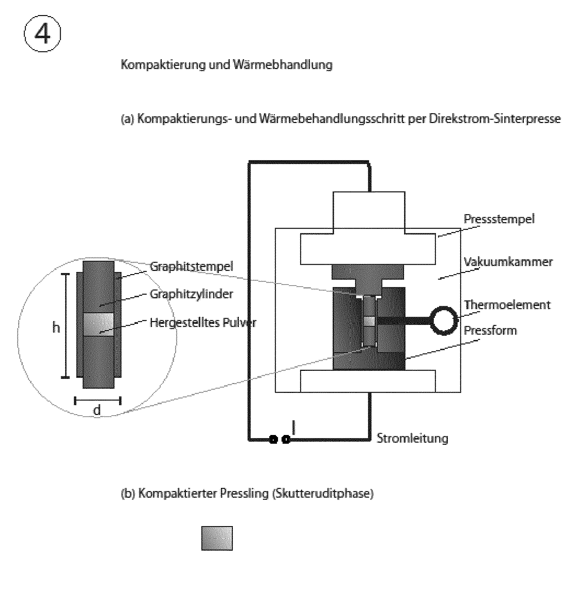

In Schritt 1 (siehe Fig. 1) wird die Herstellung der Vorprodukte illustriert.

Die Herstellung wird unter inerten Bedingungen durchgeführt und beginnt mit den elementaren Ausgangsprodukten (beispielsweise Indium und Kobalt), von denen mindestens eines die Form einer Folie besitzt (beispielsweise Kobaltfolie). Eines der Ausgangsprodukte (beispielsweise In) wird durch zwei Folien (beispielsweise Co) abgedeckt. Anschließend wird die Folie durch eine mechanische Vorrichtung an den äußeren Kanten gefalzt und abgeschnitten. Das Ausgangprodukt innerhalb der Folien ist daneben vor weiterer Oxidation und Verunreinigung geschützt. Die Handhabung ist erleichtert und das eingeschlossene Ausgangsprodukt wird durch die hohe Schmelztemperatur der Folie (die Schmelztemperatur für Kobalt beträgt 1495°C bzw. für Indium 157°C) erst spät für die chemische Reaktion bereitgestellt und schlägt sich nicht an der Innenwand des Tiegels in der Gasverdüsungsanlage nieder.

In Schritt 2 werden die Vorprodukte aus Schritt 1 und weitere notwendigen Edukte in die Gasverdüsungsanlage überführt. Die weiteren Edukte sind vor allem die Hauptprodukte der Skutteruditkomposition (beispielsweise Sb, Fe, Co). Die Edukte liegen wie die Vorprodukte in einer stückigen Form vor, das heißt es wird auf die Verwendung von Pulvern verzichtet, was wiederum eine Erleichterung der Handhabung und der Sicherheitsmaßnahmen bedeutet.

Dabei ist die Reihenfolge, in der die Elemente des Skutterudits in die Schmelze eingebracht werden aufgrund der Reaktionskinetik von erheblicher Relevanz. Das gleichzeitige Aufschmelzen aller Bestandteile des Skutterudits, wie es im Stand der Technik beschrieben ist, führt zur Ausbildung unerwünschter Nebenprodukte. Im Besonderen neigt Eisen dazu eine Reaktion mit den Metallen der seltenen Erden (3. Nebengruppe des Periodensystems und die Lanthanoide) einzugehen, die für die weitere chemische Reaktion in die Skutteruditphase nachteilhaft ist. Das wirkt sich anschließend negativ auf die Effizienz des thermoelektrischen Skutteruditmaterials aus.

Im Gegensatz hierzu offenbart die vorliegende Erfindung, dass zunächst in einem ersten Schritt (Schritt 1) Vorprodukte hergestellt werden, welche anschließend in einem nächsten Schritt (Schritt 2) mit weiter notwendigen Edukten in eine Gasverdüsungsanlage überführt werden. Dies führt zu einer deutlich geringeren Ausbildung von Nebenprodukten und damit zu einer verbesserten Effizienz des thermoelektrischen Skutteruditmaterials.

In Schritt 3 werden die Materialien aufgeschmolzen. Die Schmelztemperatur beträgt etwa 1150°C. Nach der Homogenisierung der Schmelze wird diese durch eine kleine Öffnung geführt. Der Schmelzstrahl trifft dann auf das Gasgemisch und kühlt abrupt auf Raumtemperatur (20 bis 25 °C) ab. Das Gas besteht aus einem inerten Teil (beispielsweise Ar) und einem reaktiven Teil (beispielsweise N₂, H₂). Mit dem reaktiven Teil können die im Material enthaltenen Verunreinigungen (beispielsweise O, C) eine chemische Reaktion eingehen und können dabei aus der Skutteruditkomposition entfernt werden. Durch den reaktiven Teil des Gases kann das oxidationsanfällige neu gebildete Pulver vor Oxidation geschützt werden. Das hergestellte Pulver hat die gewünschte Skutteruditkomposition (beispielsweise Baₓ₁Inₓ₂Co₄Sb₁₂₋ₓ₂). Die anderen Produkte, welche durch Reaktion des reaktiven Teils des Gases mit dem Material erhalten werden, können flüchtig sein beziehungsweise sind im Pulver als Ausscheidungen sehr fein verteilt. Hierdurch kann eine Verbesserung des thermoelektrischen Skutteruditmaterials erzielt werden.

In Schritt 4 wird das Pulver kompaktiert und über die Wärmezufuhr und den angelegten Druck in die Skutteruditphase überführt. Das Pulver wird davor in eine Graphitpressform eingefüllt und in die Kammer einer Direktstrom-Sinteranlage überführt. Die Temperatur wird durch ein Thermoelement gemessen. Die Wärme (beispielsweise 600°C) wird über die Einspeisung von Strom in die Pressform und in das Pulver eingebracht (Joulsche Wärme). Eine Hydraulik kann parallel dazu den erforderlichen Druck aufbauen (beispielsweise 50 MPa) und das Pulvermaterial verdichten. Der Vorgang dauert mehrere Minuten bis zu wenigen Stunden, so dass die Phasenumwandlung nahezu vollständig ablaufen kann. Der hergestellte Pressling hat eine zylindrische Form und besitzt die gewünschte Skutteruditphase mit der erwünschten Skutteruditkomposition.

## Patentansprüche

1. Verfahren zur Herstellung von Skutterudit der chemischen Formel
RᵢS_{y}A₄B_{12-y},
wobei
Rᵢ für ein oder mehrere Elemente (i=1,2,3,...) aus der Gruppe der (Erd-)Alkalielemente, der Gruppe der Seltenen Erden steht,
S_{y} für Füllelemente der Gruppe 13 und 14, die teilweise den Gitterplatz des Atoms B besetzen (bspw. Sn, In, Ga), steht,
A für wenigstens ein oder mehrere chemische Elemente der Gruppe der Übergangsmetalle steht, wobei A durch wenigstens ein oder mehrere Elemente der Gruppe 8 und 10 stöchiometrisch ersetzt werden kann und
B für wenigstens ein chemisches Element der Gruppe 15 steht, wobei B durch wenigstens ein oder mehrere Elemente der Gruppe 14 und 16 ersetzt werden kann durch
(a) Verschmelzen der elementaren Metalle und gegebenenfalls weiterer Edukte in einem Lichtbogen unter Inertgasatmosphäre, wobei man wenigstens eines der Ausgangsmaterialien in Form einer geschlossenen Folie einsetzt, in die wenigstens ein Ausgangsmaterial eingeschlossen ist,
(b) anschließendes Überführen der Schmelze in eine Gasverdüsungsanlage,
(c) anschließendes Abkühlen auf Raumtemperatur (20 bis 25 °C) und
(d) anschließendes Kompaktieren des erhaltenen Pulvers unter Wärmezufuhr und Druck.

2. Verfahren nach Anspruch 1, **dadurch gekennzeichnet, dass** man die Edukte in stückiger Form einsetzt.

3. Verfahren nach einem der Ansprüche 1 bis 2, **dadurch gekennzeichnet, dass** Rᵢ für Ce, La, Ga und S_{y} für In, Ga und/oder Sn steht.

4. Verfahren nach einem der Ansprüche 1 bis 3, **dadurch gekennzeichnet, dass** A für Co oder Fe steht, wobei A durch Ni stöchiometrisch ersetzt werden kann.

5. Verfahren nach einem der Ansprüche 1 bis 4, **dadurch gekennzeichnet, dass** B für Sb steht, wobei B durch Sn teilweise ersetzt werden kann.

6. Verfahren nach einem der Ansprüche 1 bis 5, **dadurch gekennzeichnet, dass** man in der Gasverdüsungsanlage ein Gasgemisch mit einem Inertanteil, insbesondere Stickstoff und gegebenenfalls einem Reaktivanteil, insbesondere Wasserstoff, einsetzt.

7. Verfahren nach Anspruch 6, **dadurch gekennzeichnet, dass** der Reaktivgasanteil bis zu 5 Volumen % beträgt.

## Claims

1. A process for producing skutterudite of chemical formula
RᵢS_{y}A₄B_{12-y},
wherein
Rᵢ represents one or more elements (i = 1, 2, 3, ...) of the group of alkali and alkaline earth metals, and rare earth metals;
S_{y} represents filler elements of groups 13 and 14 that in part occupy the lattice site of atom B (for example, Sn, In, Ga);
A represents at least one or more chemical elements of the group of transition metals, wherein A can be replaced stoichiometrically by at least one or more elements of groups 8 and 10; and
B represents at least one chemical element of group 15, wherein B can be replaced by at least one or more elements of groups 14 and 16; by
(a) melting and fusing the elemental metals and optionally other starting materials in a light arc under an inert gas atmosphere, wherein at least one of the starting materials is employed in the form of a closed sheet in which at least one starting material is enclosed;
(b) subsequently transferring the melt into a gas atomization plant;
(c) subsequently cooling down to room temperature (20 to 25 °C); and
(d) subsequently compacting the powder obtained with heat supply and under pressure.

2. The process according to claim 1, **characterized in that** the starting materials are employed in a lumpy form.

3. The process according to either of claims 1 to 2, **characterized in that** Rᵢ represents Ce, La, Ga, and S_{y} represents In, Ga and/or Sn.

4. The process according to any of claims 1 to 3, **characterized in that** A represents Co or Fe, wherein A can be replaced stoichiometrically by Ni.

5. The process according to any of claims 1 to 4, **characterized in that** B represents Sb, wherein B can be in part replaced by Sn.

6. The process according to any of claims 1 to 5, **characterized in that** a mixture of gases comprising an inert fraction, especially nitrogen, and optionally a reactive fraction, especially hydrogen, is employed in said gas atomization plant.

7. The process according to claim 6, **characterized in that** the proportion of reactive gas is up to 5% by volume.

## Revendications

1. Procédé de production de skuttérudite de formule chimique
RᵢS_{y}A₄B_{12-y},
où
Rᵢ représente un ou plusieurs éléments (i = 1, 2, 3, ...) du groupe des métaux alcalins et alcalino-terreux, du groupe des terres rares,
S_{y} représente des éléments de charge des groupes 13 et 14, qui occupent en partie le site réticulaire de l'atome B (par ex. Sn, In, Ga),
A représente au moins un ou plusieurs éléments chimiques du groupe des métaux de transition, où A peut être remplacé stoechiométriquement par au moins un ou plusieurs éléments des groupes 8 et 10, et
B représente au moins un élément chimique du groupe 15, où B peut être remplacé par au moins un ou plusieurs éléments des groupes 14 et 16, par des étapes consistant à :
(a) fondre ensemble les métaux élémentaires et éventuellement autres produits de départ dans un arc électrique sous atmosphère de gaz inerte, dans lequel au moins un des produits de départ est utilisé sous forme d'une feuille fermée, dans laquelle au moins un produit de départ est enfermé,
(b) ensuite transférer la masse fondue dans une installation d'atomisation à l'aide d'un gaz,
(c) ensuite refroidir à température ambiante (20 à 25 °C), et
(d) ensuite compacter la poudre obtenue avec apport de chaleur et sous pression.

2. Procédé selon la revendication 1, **caractérisé en ce que** lesdits produits de départ sont utilisés sous forme de morceaux.

3. Procédé selon l'une des revendications 1 à 2, **caractérisé en ce que** Rᵢ représente Ce, La, Ga, et S_{y} représente In, Ga et/ou Sn.

4. Procédé selon l'une quelconque des revendications 1 à 3, **caractérisé en ce qu'**A représente Co ou Fe, où A peut être remplacé stoechiométriquement par Ni.

5. Procédé selon l'une quelconque des revendications 1 à 4, **caractérisé en ce que** B représente Sb, où B peut être remplacé en partie par Sn.

6. Procédé selon l'une quelconque des revendications 1 à 5, **caractérisé en ce que** un mélange de gaz avec une fraction inerte, notamment de l'azote, et éventuellement une fraction réactive, notamment de l'hydrogène, est utilisé dans ladite installation d'atomisation à l'aide d'un gaz.

7. Procédé selon la revendication 6, **caractérisé en ce que** la part du gaz réactif représente jusqu'à 5 % volumique.
